# EUROPÄISCHE PATENTSCHRIFT

(11) **EP 0 413 389 B1**
(45) Veröffentlichungstag und Bekanntmachung des Hinweises auf die Patenterteilung: **25.05.1994**
(21) Anmeldenummer: 90202176.5
(22) Anmeldetag: 10.08.1990
(51) Int. Cl.: C23C 16/44, C23C 16/26

(54) **Verfahren zur Abscheidung mikrokristalliner Festkörperartikel aus der Gasphase mittels Chemical Vapour Deposition**
Process for the deposition of microcrystalline solid particles from the gas phase by chemical vapour deposition
Procédé de déposition de particules microcristallines solides à partir de la phase gazeuse par dépôt chimique en phase vapeur

(30) Priorität: 17.08.1989 DE 3927133
(43) Veröffentlichungstag der Anmeldung: 20.02.1991
(73) Patentinhaber: Philips Patentverwaltung GmbH, 22335 Hamburg (DE); Philips Electronics N.V., 5621 BA Eindhoven (NL)
(72) Erfinder: Bachmann, Klaus Peter, Dr., D-5100 Aachen (DE); Lydtin, Hans, Dr., D-5190 Stolberg (DE); Warnier, Jaques, Ing.grad., NL-6245 GJ Eijsden (NL)
(74) Vertreter: Kupfermann, Fritz-Joachim, Dipl.-Ing.

(56) Entgegenhaltungen:
- FR-A- 2 397 067
- US-A- 4 647 512
- APPLIED PHYSICS LETTERS, Band 51, Nr. 10, 7. September 1987, Seiten 737-739; S. MATSUMOTO et al.: "Synthesis of diamond films in a rf induction thermal plasma"

## Beschreibung

Die Erfindung betrifft ein Verfahren zur Abscheidung mikrokristalliner Diamantpartikel aus der Gasphase mittels Chemical Vapour Deposition (CVD), bei dem die abzuscheidenden Diamantpartikel bei einem Druck im Bereich von 0,01 bis 1000 hPa (10⁻⁵ bis 1 bar) und bei einer gerichteten Gasströmung an einem auf eine Temperatur im Bereich von 450 bis 1200°C aufgeheizten Substrat abgeschieden werden.

Die Abscheidung mikrokristalliner Festkörper aus der Gasphase mittels Chemical Vapour Deposition (CVD) wird für breite Anwendungsbereiche benutzt für die Herstellung von freitragenden Formkörpern oder auch zur Ausbildung von Beschichtungen auf unterschiedlichsten Substraten.

Ganz allgemein ist für einen CVD-Prozeß charakteristisch, daß eine Mischung von Gasen bei einer relativ hohen Temperatur mit einer Substratoberfläche in Wechselwirkung tritt unter Zersetzung mindestens eines am Gasgemisch beteiligten Gases und Abscheidung eines Reaktionsproduktes in fester Phase an der Substratoberfläche. Der konventionelle CVD-Prozeß bedingt hohe Temperaturen, reaktive Gase und eine für die Durchführung eines solchen Verfahrens geeignete Vorrichtung. Typische Prozeßparameter sind Temperaturen im Bereich von 450 bis zu 2500°C, Drücke im Bereich von 0,01 bis 1000 hPa (10⁻⁵ bis 1 bar) und ein Prozeßgasgemisch aus mindestens einem reaktiven Gas und weiteren Gasen wie inerten, oxidierenden oder reduzierenden Gasen.

Die Reaktionsprodukte (Festkörperpartikel) werden dementsprechend erhalten durch
Pyrolyse (z.B.: CH₃SiCl₃ → SiC + 3HCl) oder
Reduktion (z.B.: WF₆ + 3H₂ → W + 6HF) oder
Oxidation (z.B.: SiH₄ + O₂ → SiO₂ + 2H₂) oder
Co-Reduktion (z.B.: TiCl₄ + 2BCl₃ + 5H₂ → TiB₂ + 10 HCl).

Die Aktivierung des Prozeßgasgemisches innerhalb des Reaktors erfolgt in einer Anregungszone (Gasphasenbereich mit maximalem Energieinhalt), die beispielsweise über ein Plasma, das durch Einkopplung von Mikrowellen- oder Hochfrequenz-Energie oder Energie aus einem elektrischen Gleichspannungsfeld, über einen induktiv beheizten Draht oder über eine Flamme erzeugt werden kann. In der Anregungszone werden die Gasphasenreaktionen stimuliert und eine Abscheidung der Reaktionsprodukte erfolgt anschließend auf dem vorzugsweise in einem Abstand zur Anregungszone positionierten Substrat, das auf einem üblicherweise temperaturgeregelten Substrathalter angeordnet ist. Die Restgase werden mittels einer Vakuumpumpe aus dem Reaktor abgepumpt.

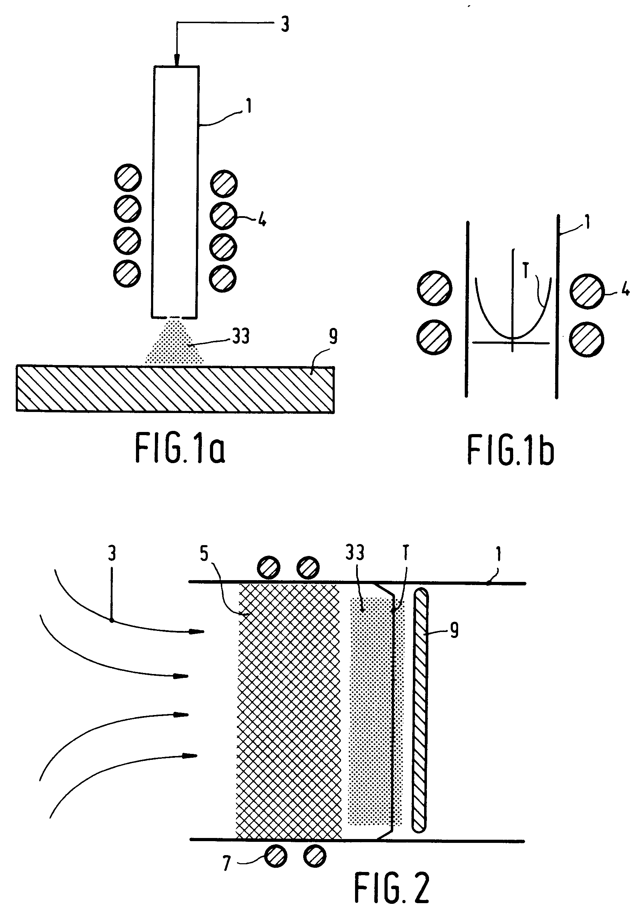

Aus der Veröffentlichung von W. Yarbrough und R. Roy in Extended Abstracts der Spring Meeting Session der Materials Research Society, USA, April 1988, Seite 33 ff ist bekannt, eine Gasphase für einen CVD-Prozeß zur Abscheidung von Diamant in einem rohrförmigen Reaktor energetisch über eine Widerstandsheizung anzuregen. In den Figuren 1a, 1b ist dieser Stand der Technik schematisch dargestellt.

Das Prozeßgasgemisch 3 wird in den rohrförmigen Reaktor 1 eingeleitet und innerhalb einer Anregungszone (Zone mit maximalen Energieinhalt), die durch die Widerstandsheizung 4 erzeugt wird, auf das erforderliche Reaktionsenergieniveau gebracht.

Das aktivierte Prozeßgasgemisch 33 tritt am Ende des Reaktors 1 aus und auf einem im Abstand zum Reaktor 1 angeordneten Substrat 9 wird Diamant abgeschieden. In Figur 1b ist die Anregungszone schematisch als Ausschnitt mit ihrem Temperaturprofil T über den Querschnitt des Reaktors 1 dargestellt. Der Nachteil eines solchen Vorgehens besteht in der Inhomogenität der Anregung über den Querschnitt der anzuregenden Gasphase. Ein Teil der Gase, zum Beispiel im Zentrum des Reaktorrohres, kann unter Umständen energetisch noch nicht auf Reaktionsniveau gebracht worden sein, während andere Bereiche, zum Beispiel an der Reaktorwandung, schon soweit angeregt sind, daß die Abscheidereaktionen bereits zur homogenen Nukleation der abzuscheidenden Materialien in der Gasphase führt, statt zur Bildung von Schichten auf dem Substrat. Neben der Partikelbildung bereits in der Gasphase ergibt sich der weitere unerwünschte Effekt, daß die auf dem Substrat abgeschiedene Schicht inhomogen bezüglich Zusammensetzung und Schichtdicke ist.

Aus den Schriften US-A-4 647 512 und FR-A-2 397 067 sind Niederdruck-RF-Plasma-CVD-Verfahren bekannt, bei denen unterhalb der porös ausgeführten Elektroden, d.h. im evakuierten Reaktorbereich ein Plasma gezündet wird, das eine chemische Reaktion induziert. Die porösen Platten dienen dabei nicht als Anregungszone, sie können auch kalt bleiben, sondern als Diffusor für die Reaktionsgase. Mit diesen Vorrichtungen wird DLC hergestellt, d.h. amorphes Material, das nicht kristallin ist und deshalb weder Härte noch elektrische noch thermische Eigenschaften hat, die mit Diamant vergleichbar wären.

Der Erfindung liegt die Aufgabe zugrunde, das eingangs genannte Verfahren dahingehend zu verbessern, daß die Anregung des Prozeßgases innerhalb der Zone mit maximalem Energieinhalt optimiert wird.

Diese Aufgabe wird erfindungsgemäß dadurch gelöst, daß das Prozeßgas durch einen porösen Zwischenkörper einer Dicke im Bereich von 2 bis 30 mm aus einem für eine Anwendung bei Temperaturen bis zu 2500°C geeigneten Material, der sich in der Zone mit maximalem Energieinhalt innerhalb des Reaktors befindet, hindurchgeleitet und in diesem angeregt wird, wonach die Abscheidung der Diamantpartikel auf dem Substrat erfolgt.

Nach vorteilhaften Weiterbildungen des erfindungsgemäßen Verfahrens werden als Zwischenkörper geschüttete, auf einem gasdurchlässigen Träger befindliche oder zu einem Formkörper verpreßte Pulver oder poröse Festkörper mit durchgehenden Poren einer Porengröße im Bereich von 1 bis 100 µm, beispielsweise aus porösen Sintermetallen, poröser Keramik oder aus porösem Kohlenstoff, wie Schaumkohle oder Graphitfilz, eingesetzt.

Nach vorteilhaften weiteren Ausgestaltungen des Verfahrens gemäß der Erfindung wird ein CVD-Prozeß angewendet, bei dem die für den Abscheideprozeß erforderliche Energie als Mikrowellenenergie oder als Hochfrequenzenergie oder durch direkten Stromdurchgang durch den Zwischenkörper in den Zwischenkörper eingekoppelt wird.

Mit dem erfindungsgemäßen Verfahren ist der Vorteil verbunden, daß die Anregung des Prozeßgases innerhalb der Zone mit maximalem Energieinhalt optimiert wird. Der gesamte Prozeßgasstrom passiert den porösen Zwischenkörper. Über multiplen Stoß der Moleküle der anzuregenden Gasphase mit den durch die in den Zwischenkörper eingekoppelte Energie erhitzten Porenwandungen des Zwischenkörpers werden die Gasmoleküle gleichmäßig über den gesamten zur Verfügung stehenden Querschnitt des Zwischenkörpers angeregt. Die Qualität der daraus resultierenden Abscheidung ist dann ebenfalls über den gesamten Anregungsquerschnitt homogen. Die Reaktionsführung kann jetzt so erfolgen, daß genau die für die Bildung des gewünschten Materials erforderlichen Anregungsbedingungen über den gesamten Reaktorquerschnitt eingehalten werden können.

Überhitzte Randzonen oder niederenergetische Kernzonen des Strömungsprofils werden auf diese Weise vermieden. Die Fläche mit homogener Abscheidung entspricht weitgehend der Querschnittsfläche des porösen, die Anregung der Gasphase bewirkenden Zwischenkörpers.

Die Erfindung wird nachstehend anhand eines Ausführungsbeispiels in ihrer Wirkungsweise erläutert.
Es zeigen:
- Figur 1a,1b: schematische Darstellung einer CVD-Vorrichtung mit Temperaturprofil der Anregungszone gemäß dem Stand der Technik,
- Figur 2: schematische Darstellung einer CVD-Vorrichtung zur Durchführung des erfindungsgemäßen Verfahrens.

In einen Reaktor 1 (vergleiche Fig. 2) wird ein Prozeßgasgemisch 3 eingespeist, das einen porösen Zwischenkörper 5 durchströmt. Der Zwischenkörper 5 befindet sich in der Zone mit maximalem Energieinhalt, wobei die für die Anregung des Prozeßgases 3 erforderliche Energie bei dem hier beschriebenen Beispiel mittels einer außerhalb des Reaktors 1 angeordneten Induktionsspule 7 in den Reaktor 1 und den Zwischenkörper 5 eingekoppelt wird. Im Zwischenkörper 5 wird das Prozeßgasgemisch 3 energetisch auf Reaktionsniveau (aktiviertes Prozeßgasgemisch 33) angehoben, verläßt den Zwischenkörper 5 aufgrund der Strömungsgeschwindigkeit jedoch so schnell, daß eine Abscheidung der Reaktionsprodukte (Festkörperpartikel) erst auf einem im Abstand zum Zwischenkörper 5 angeordneten Substrat 9 abgeschieden wird.

Mit T ist das Temperaturprofil des aktivierten Prozeßgasgemisches 33 bezeichnet.

Das Substrat kann je nach Art des Abscheideprozesses aufgeheizt oder gekühlt sein.

Als Materialien für den porösen Zwischenkörper 5 kommen praktisch alle Materialien in betracht, die als poröse Festkörper oder als Pulverschüttungen verarbeitbar und für Prozeßtemperaturen bis zu 2500 °C geeignet sind. Z.B. können hierfür Pulver aus Diamant oder Graphit, aus Hartstoffen wie Oxiden, Carbiden oder Nitriden oder aus Metallen, wie beispielsweise Wolfram, eingesetzt werden. Es können mit Vorteil jedoch auch Zwischenkörper 5 in Form poröser Festkörper mit durchgehenden Poren einer Porengröße im Bereich von 1 bis 100 µm aus z.B. porösen Sintermetallen wie Wolfram, Molybdän oder Tantal, poröser Keramik, wie Aluminiumoxid oder Siliciumnitrid, oder aus porösem Kohlenstoff, wie Schaumkohle oder Graphitfilz, eingesetzt werden.

Zur Abscheidung einer polykristallinen Diamantschicht wird ein Prozeßgasgemisch 3 bestehend aus 0,5 % Methan und 99,5 % Wasserstoff in den rohrförmigen doppelwandigen wassergekühlten Reaktor 1 eingeleitet, um dessen Außenwand herum die Induktionsspule 7 angebracht ist. Durch die von einem 13,45 MHz-Sender abgegebene HF-Energie wird der im Inneren des Reaktors 1 befindliche Zwischenkörper 5 auf eine Temperatur von etwa 2300 °C aufgeheizt.

Der Zwischenkörper 5 bestand im vorliegenden Beispiel aus porösem Graphit und hatte einen Durchmesser von 2 cm und eine Dicke von 0,5 cm. Der Gesamtdurchsatz des Prozeßgasgemisches 3 betrug 500 sccm/min, der Gesamtdruck im Reaktor 1 betrug etwa 65 hPa (mbar). Im Inneren des porösen Zwischenkörpers 5 wird das Prozeßgasgemisch 3 gleichmäßig über den gesamten Querschnitt des Zwischenkörpers 5 erhitzt, so daß die Gasphase bei Austritt aus dem Zwischenkörper 5 hoch angeregt ist (aktiviertes Prozeßgasgemisch 33) und auf der, in einem Abstand zum Zwischenkörper 5 von etwa 8 mm befindlichen, auf eine Temperatur von 950°C aufgeheizten Oberfläche des Substrates 9 aus Silicium eine homogene Diamantschicht eines Durchmessers von etwa 2 cm abgeschieden wird.

## Patentansprüche

1. Verfahren zur Abscheidung mikrokristalliner Diamantpartikel aus der Gasphase mittels Chemical Vapour Deposition (CVD), bei dem die abzuscheidenden Diamantpartikel bei einem Druck im Bereich von 0,01 bis 1000 hPa (10⁻⁵ bis 1 bar) und bei einer gerichteten Gasströmung an einem auf eine Temperatur im Bereich von 450 bis 1200°C aufgeheizten Substrat abgeschieden werden,
dadurch gekennzeichnet,
daß das Prozeßgas durch einen porösen Zwischenkörper einer Dicke im Bereich von 2 bis 30 mm aus einem für eine Anwendung bei Temperaturen bis zu 2500°C geeigneten Material, der sich in der Zone mit maximalem Energieinhalt innerhalb des Reaktors befindet, hindurchgeleitet und in diesem angeregt wird, wonach die Abscheidung der Diamantpartikel auf dem Substrat erfolgt.

2. Verfahren nach Anspruch 1,
dadurch gekennzeichnet,
daß als Zwischenkörper geschüttete, auf einem gasdurchlässigen Träger befindliche oder zu einem Formkörper verpreßte Pulver eingesetzt werden.

3. Verfahren nach Anspruch 1,
dadurch gekennzeichnet,
daß als Zwischenkörper ein poröser Festkörper mit durchgehenden Poren einer Porengröße im Bereich von 1 bis 100 µm eingesetzt wird.

4. Verfahren nach Anspruch 3,
dadurch gekennzeichnet,
daß Zwischenkörper aus porösen Sintermetallen eingesetzt werden.

5. Verfahren nach Anspruch 3,
dadurch gekennzeichnet,
daß Zwischenkörper aus poröser Keramik eingesetzt werden.

6. Verfahren nach Anspruch 3,
dadurch gekennzeichnet,
daß Zwischenkörper aus porösem Kohlenstoff, vorzugsweise aus Schaumkohle oder Graphitfilz, eingesetzt werden.

7. Verfahren nach mindestens einem der Ansprüche 1 bis 6,
dadurch gekennzeichnet,
daß die für den Abscheideprozeß erforderliche Energie als Mikrowellenenergie in den Zwischenkörper eingekoppelt wird.

8. Verfahren nach mindestens einem der Ansprüche 1 bis 6,
dadurch gekennzeichnet,
daß die für den Abscheideprozeß erforderliche Energie als Hochfrequenzenergie in den Zwischenkörper eingekoppelt wird.

9. Verfahren nach mindestens einem der Ansprüche 1 bis 6,
dadurch gekennzeichnet,
daß die für den Abscheideprozeß erforderliche Energie durch direkten Stromdurchgang durch den Zwischenkörper in den Zwischenkörper eingekoppelt wird.

## Claims

1. A method of depositing microcrystalline diamond particles from the gas phase by means of Chemical Vapour Deposition (CVD), in which the diamond particles are deposited on a substrate heated to a temperature ranging from 450 to 1200°C at a pressure in the range from 0.01 to 1000 hPa (10⁻⁵ to 1 bar) and at a directed gas flow, characterized in that the process gas is passed through a porous intermediate body having a thickness in the range from 2 to 30 mm and consisting of a material suitable for use at temperatures up to 2500°C, which body is present in the zone having the maximum energy content within the reactor, while the process gas is excited in said intermediate body, whereafter the diamond particles are deposited on the substrate.

2. A method as claimed in Claim 1, characterized in that loose powders which are present on a gas-permeable support or powders which are compressed to a moulded body are used as intermediate bodies.

3. A method as claimed in Claim 1, characterized in that a porous solid body having through-pores with a size ranging from 1 to 100 µm is used as an intermediate body.

4. A method as claimed in Claim 3, characterized in that intermediate bodies of porous sintered metals are used.

5. A method as claimed in Claim 3, characterized in that intermediate bodies of porous ceramic material are used.

6. A method as claimed in Claim 3, characterized in that intermediate bodies of porous carbon, preferably of foamed carbon or graphite felt are used.

7. A method as claimed in any one of Claims 1 to 6, characterized in that the energy required for the deposition process is coupled into the intermediate body as microwave energy.

8. A method as claimed in any one of Claims 1 to 6, characterized in that the energy required for the deposition process is coupled into the intermediate body as high-frequency energy.

9. A method as claimed in any one of Claims 1 to 6, characterized in that the energy required for the deposition process is coupled into the intermediate body by means of the direct passages of current through said body.

## Revendications

1. Procédé de dépôt de particules de diamant microcristallines à partir de la phase gazeuse par la mise en oeuvre de Chemical Vapour Deposition (CVD), les particules de diamant étant déposées sur un substrat chauffé à une température comprise entre 450 et 1200°C, dans le cas d'une pression comprise entre 0,01 et 1000 hPa (10⁻⁵ à 1 bars) et d'un flux de gaz orienté, caractérisé en ce que le gaz de processus est passé à travers un corps poreux intermédiaire présentant une épaisseur comprise entre 2 et 30 mm, constitué d'un matériau approprié résistant à des températures allant jusqu'à 2500°C et disposé dans la zone présentant le contenu énergétique maximal dans le réacteur et en ce que le gaz de processus est excité dans ledit corps, les particules de diamant étant subséquemment déposées sur le substrat.

2. Procédé selon la revendication 1, caractérisé en ce que l'on utilise comme corps intermédiaire des poudres en vrac distribués sur un support perméable au gaz ou des poudres pressés en corps moulé.

3. Procédé selon la revendication 1, caractérisé en ce que l'on utilise comme corps intermédiaire un corps solide poreux présentant des pores ouverts dont la grosseur est comprise entre 1 et 100 µm.

4. Procédé selon la revendication 3, caractérisé en ce que l'on utilise des corps intermédiaires en métaux frittés poreux.

5. Procédé selon la revendication 3, caractérisé en ce que l'on utilise des corps intermédiaires en céramique poreuse.

6. Procédé selon la revendication 3, caractérisé en ce que l'on utilise des corps intermédiaires en carbone fritté, avantageusement en carbone mousse ou en feutre de graphite.

7. Procédé selon l'une quelconque des revendications 1 à 6, caractérisé en ce que l'énergie indispensable au procédé de dépôt est appliquée au corps intermédiaire comme énergie à micro-ondes.

8. Procédé selon l'une quelconque des revendications 1 à 6, caractérisé en ce que l'énergie indispensable au procédé de dépôt est appliquée au corps intermédiaire comme énergie à haute fréquence.

9. Procédé selon l'une quelconque des revendications 1 à 6, caractérisé en ce que l'énergie indispensable au procédé de dépôt est appliquée au corps intermédiaire comme flux de courant direct traversant le corps intermédiaire.
